Europäisches Patentamt

European Patent Office

Office européen des brevets

(19)

(11) **EP 0 607 393 B1**

(12) **EUROPÄISCHE PATENTSCHRIFT**

(45) Veröffentlichungstag und Bekanntmachung des Hinweises auf die Patenterteilung:
**16.12.1998 Patentblatt 1998/51**

(21) Anmeldenummer: **93917527.9**

(22) Anmeldetag: **06.08.1993**

(51) Int Cl.[6]: **H03H 21/00**

(86) Internationale Anmeldenummer:
**PCT/DE93/00697**

(87) Internationale Veröffentlichungsnummer:
**WO 94/05080 (03.03.1994 Gazette 1994/06)**

(54) **NEURONALE FILTERARCHITEKTUR ZUR NICHTLINEAREN ADAPTIVEN STÖRINTERFERENZBESEITIGUNG**

NEURAL FILTER ARCHITECTURE FOR THE NON-LINEAR, ADAPTATIVE ELIMINATION OF DISTURBING INTERFERENCES

ARCHITECTURE NEURONALE DE FILTRAGE NON-LINEAIRE ADAPTATIF D'INTERFERENCES PERTURBATRICES

(84) Benannte Vertragsstaaten:
**DE FR GB**

(30) Priorität: **11.08.1992 DE 4226598**

(43) Veröffentlichungstag der Anmeldung:
**27.07.1994 Patentblatt 1994/30**

(73) Patentinhaber: **SIEMENS AKTIENGESELLSCHAFT 80333 München (DE)**

(72) Erfinder: **TRESP, Volker, Dr. D-80539 München (DE)**

(56) Entgegenhaltungen:
- **IEEE INT. CONF. ON COMMUNIC. ICC'90; 15-19 04/90; KAORU ARAKAWA et al : A NONLINEAR DIGITAL FILTER USING MULTI-LAYERED NEURAL NETWORKS; P. 424-428**
- **IEEE TRANSACTIONS ON CIRCUITS AND SYSTEMS Bd. 37, Nr. 11 , November 1990 , NEW YORK US Seiten 1436 - 1440 XP000173265 J. SZTIPANOVITS 'ADAPTIVE PROCESSING WITH NEURAL NETWORK CONTROLLED RESONATOR-BANKS'**

**Beschreibung**

Neuronale Netzwerke haben bereits in einer Vielzahl von Anwendungen adaptiver nichtlinearer Filter Verwendung gefunden. Bei den meisten dieser Anwendungen ist die Zahl der Eingangsvariarablen des Netzes klein und das Trainingssignal ist verhältnismäßig rauscharm. Wenn diese Bedingungen nicht vorliegen, ist es häufig schwierig, ein Netzwerk zu trainieren, besonders dann, wenn eine schnelle Adaption erforderlich ist.

Die Übertragungscharakteristik eines allgemeinen diskreten linearen Filters kann durch die Formel

$$(1) \quad g(n) = \sum_{i=0}^{M} f(n-i) \cdot k(i) + \sum_{i=0}^{M} g(n-i) \cdot r(i)$$

beschrieben werden. Hierbei bezeichnet g(n) die Ausgangsvariable des linearen Filters zur Zeit n, f(n-i) bezeichnet die Eingangsvariable des Filters zur Zeit n-i und die Funktionen k und r bezeichnen die Antwort funktionen des diskreten linearen Filters. Für den Fall, in dem die Funktion r für alle Zeitpunkte i verschwindet, liegt ein sog. FIR-Filter (Filter mit endlicher Impulsantwort) vor. Die Ausgangsfunktion des Filters ist dabei eine lineare Superposition momentaner und vergangener Eingangssignale und vergangener Ausgangssignale.

Diese Filterstruktur läßt sich zu einer nichtlinearen Filterarchitektur verallgemeinern, welche durch die Formel

$$(2) \quad g(n) = N[f(n),..., f(n-M);g(n-1),...,g(n-K)]$$

gegeben ist. Hierbei hängt die Ausgangsfunktion N in nichtlinearer Weise von den Eingangs- und Ausgangssignalen ab. Die nichtlineare Funktion N kann dabei durch ein neuronales Netzwerk approximiert werden, was bei der von Lapedes und Farber vorgeschlagenen Filterarchitektur der Fall ist (A. Lapedes, R. Farber, "How neural nets work." In Neural information processing systems, ed. D. Z. Anderson,, pp, 442-456, New York, American Institute of Physics, 1988). Waibel (A. Waibel, "Modular constuction of time-delay neural networks for speech recognition", Neural Computation, Vol. 1, pp. 39-46, 1989) hat ein neuronales Netzwerk beschrieben, bei dem den Eingangsaariablen lediglich die Einganssignals vergangener Zeitpunkt zugeführt werden.

Aus (K. Arakawa, A Nonlinear Digital Filter Using Multi-Layered Neural Networks, IEEE Int. Conf. on Communications, Vol. 2, S.424-428 ICC '90, September 1990) ist ein 3-schichtiges Neuronales Netz bekannt. An dem Neuronalen Netz liegen Eingangssignale an, die zu einem Zeitpunkti, welcher Zeitpunkti selbst kein Eingangssignal des Neuronalen Netzes ist, mehrere Werte vorangegangener Zeitpunkte aufweisen.

Im Rahmen dieser Patentanineldung sollen Systeme betrachtet werden, bei denen die Eigenschaften der Eingangsfunktionen die Eigenschaften der Ausgangsfunktion des Systems über lange Zeiten beeinflussen. Mit Hilfe rekursiver Netzwerke können derartige Systeme mit langdauernden Antwortfunktionen modelliert werden. Als Alternative dazu könnte man auch die Länge der Antwortfunktion M hinreichend groß wählen. Dies erfordert eine große Zahl von Eingangsvariablen des verwendeten neuronalen Netzwerks und hierdurch wird das Training des Netzwerks ineffizient.

Der vorliegenden Erfindung liegt deshabl die Aufgabe zugrunde, eine nichtlineare Filterarchitektur anzugeben, mit deren Hilfe langdauernde Filterantwortfunktionen implementiert werden können, welche gleichzeitig unempfindlich gegen Rauschen im Trainingssignal ist, und deren Übertragungseigenschaften schnell an eine bestimmte Aufgabenstellung anzupassen sind (schnelle Adpation).

Diese Aufgabe wird erfindungsgemäß mit Hilfe einer nichtlinearen Filterarchitektur mit Merkmalen nach Anspruch 1 gelöst. Mit dem Patentanspruch 2 soll ein Adaptionsverfahren für eine nichtlineare Filterarchitektur nach Anspruch 1 geschützt werden. Anspruch 3 definiert eine Schaltungsanordnung zur Realisierung einer nichtlinearen Filterarchitektur nach Anspruch 1.

Die erfindungsgemäße Filterarchitektur wird am einfachsten durch den mathematischen Zusammenhang

$$3) \quad g(n) = \sum_{i=0}^{M} N\big[f(n-i),i,p(n-i)\big]$$

definiert. Die nichtlineare Ubertragungsfunktion N wird hierbei durch ein neuronales Netz realisiert, mit dessen Eingangsknoten zum Zeitpunkt i das zum Zeitpunkt n-i gehörige, gegebenenfalls mehrdimensionale Eingangssignal f(n-i) des nichtlinearen Filters, ein Zeitsignal für den Zeitpunkt i und ein zum Zeitpunkt n-i gehörender Parametervektor p (n-i) verbunden ist. Das Ausgangssignal g(n) des nichtlinearen Filters zum Zeitpunkt n ergibt sich dann durch Summation über M+1 zu den Zeitpunkten n, ... n-M gehörigen Ausgangssignale des neuronalen Netzes nach der Formel (3).

Ähnlich wie bei einem FIR-Filter ist das Ausgangssignal des Filters die Summe von Antworten auf zeitlich zurückliegende Eingangssignale des Systems. Der Unterschied zu einem FIR-Filter besteht darin, daß die Antworten nichtlinear von den Eingangssignalen f(n-i), der Zeit i, die vergangen ist seit der Entstehung des Eingangssignals und dem Parametervektor p abhängt. Die Beziehung zum bekannten FIR-Filter wird dabei noch klarer, wenn man folgende Variante der erfindungsgemäßen nichtlinearen Filterarchitektur betrachtet: Nimmt man nämlich an, daß das Ausgangssignal g(n) in linearer Weise von den Eingangssignalen f(n-i) abhängt, kommt man zu der spezielleren Formel

$$(4) \quad g(n) = \sum_{i=0}^{M} f(n-i) \cdot N[i, p(n-i)]$$

bei der das neuronale Netz lediglich den Zeitindex i und den Parametervektor p als Eingangssignale verarbeitet, und die Ausgangswerte des neuronalen Netzes mit den Eingangssignalen f(n-i) multipliziert werden und anschließend über die Zeitpunkte i summiert wird. Nimmt man ferner an, daß das Filter unabhängig vom Parametervektor p ist, erhält man die noch speziellere Filterarchitektur der Formel

$$(5) \quad g(n) = \sum_{i=0}^{M} f(n-i) \cdot N[i]$$

welche einem FIR-Filter entspricht, dessen Antwortfunktion (Filterkoeffizienten) durch die Ausgangswerte eines neuronalen Netzes gegeben sind, das lediglich den Zeitindex als Eingangsvariable hat.

Die speziellen Filterarchitekturen der Formeln (4) und (5) sind sämtlich Spezialfälle der allgemein nichtlinearen Filterarchitektur, welche durch die Formel (3) gegeben ist.

Es ist ein besonderer Vorteil der durch die Formel (5) definierten Filterarchitektur, das bei dieser Filterarchitektur die Trainings zeiten gegenüber herkömmlichen FIR-Filtern im Falle sehr großer Werte für M beträchtlich reduziert werden können. Hat nämlich das neuronale Netzwerk weniger als M Parameter, kann es eine effizientere Beschreibung der Filterfunktion bereitstellen, wodurch eine Adpation mit weit weniger Trainingsaufwand möglich ist. Mit diesem Umstand hängt auch zusammen, daß das neuronale Netzwerk eine implizite Einschränkung der Komplexität der Filterantwort bewirkt. Die Komplexität eines FIR-Filters wird im allgemeinen reduziert, indem der Wert für M erniedrigt wird. Dies kann entweder durch Reduktion der Breite des Zeitfensters geschehen, was aber unerwünscht ist, da das Filter ja gerade eine langdauernde Antwortfunktion haben soll, oder indem man die Abtastfrequenz erniedrigt, wodurch aber die Bandbreite des Filters in unerwünschtem Maße herabgesetzt wird. Die Komplexität eines neuronalen Netzwerks hingegen wird durch die Zahl der Neuronen und Gewichte im Netzwerk definiert. Ein neuronales Netzwerk hat die Fähigkeit, Ressourcen in adaptiver Weise so zu verteilen, wie die diesem Netzwerk zugeführten Daten es erfordern. Das Netzwerk erlernt damit gewissermaßen während der Trainingsphase eine optimale Verteilung der Ressourcen (Neuronen und Gewichte) des Netzwerks für eine optimale Approximation der Übertragungsfunktion. Hierdurch wird vermieden, daß Ressourcen des Netzwerkes in unnötiger Weise dort verschwendet werden, wo eine gute Approximation auch mit wenigen Parametern und Ressourcen möglich ist.

In der etwas allgemeineren Variante des erfindungsgemäßen nichtlinearen Filters, die durch die Formel (4) repräsentiert wird, stellt der Parametervektor einen zusätzlichen Eingang zum Netzwerk dar. Mit Hilfe dieses Parametervektors p kann die Antwort des Filters durch externe normalerweise sehr langsam veränderliche Parameter beeinflußt werden. Für ein neuronales Netzwerk stellt aber ein neuer Parameter einfach einen zusätzlichen Eingang dar. Sollte man derartige Parameter mit Hilfe herkömmlicher FIR-Filterarchitekturen berücksichtigen, müßte man das Filter für jeden Wertesatz dieses Parametervektors neu trainieren, wodurch die Zahl der benötigten Filterkoeffizienten und damit die für das Training benötigte Zeit enorm ansteigen würde.

Schließlich gibt es eine ganze Reihe von Anwendungen, bei denen lineare Filterarchitekturen zur Modellierung der Systemeigenschaften nicht angemessen sind. Aus diesem Grunde ist die erfindungsgemäße Filterarchitektur in ihrer allgemeinsten Form eine nichtlineare Filterarchitektur gemäß der Formel (3), welche offensichtlich die spezielleren Architekturen, die durch die Formeln (4) und (5) gegeben sind, als Spezialfälle einschließt.

Die Gewichte des neuronalen Netzes werden in einer bevorzugten Ausführungsform der Erfindung adaptiert, indem jedes Gewicht W des neuronalen Netzes in der Weise verändert wird, daß ein vorgegebenes Fehlermaß E, welches die über ein vorgegebenes Zeitintervall gemittelte Abweichung der Ausgangssignale g(n) des Filters von Sollausgangssignalen $g_m(n)$ bewertet, durch die Veränderung der Gewichte des neuronalen Netzes minimiert wird.

Die erfindungsgemäße nichtlineare Filterarchitektur kann z. B. mit Hilfe einer Schaltungsanordnung mit Merkmalen nach Anspruch 3 realisiert werden. Bei dieser Schaltungsanordnung ist ein Speicher zur Speicherung des momentanen Filtereingangssignals, der momentanen Werte des Parametervektors sowie der letzten M Filtereingangssignale und Parametervektoren vorgesehen. Ferner sind Mittel vorgesehen, die für M+1 aufeinanderfolgende Zeitpunkte den Eingangs knoten des neuronalen Netzes die zu diesen Zeitpunkten gehörigen Speicherinhalte zuführen. Ferner sind Mittel zur Summation der Ausgangswerte des neuronalen Netzes über diese Zeitpunkte vorgesehen.

Die Erfindung kann zur Realisierung eines Verfahrens zur Beseitigung von Störsignalen in der digitalen Signalverarbeitung eingesetzt werden, indem eine Schaltungsanordnung oder ein Softwaresystem mit Merkmalen nach einem der Ansprüche 1 bis 3 verwendet wird. Speziell kann die Erfindung verwendet werden in einem Verfahren zur Unterdrückung der Kardiointerferenz in der Magnetoenzephalographie. Die Erfindung kann weiterhin verwendet werden zur Beseitigung von Motorgeräuschen.

Figur 1 zeigt die Signalverläufe verschiedener Signale im Zusammenhang mit der erfindungsgemäßen nichtlinearen Filterarchitektur.

Figur 2 zeigt eine schematische Darstellung der erfindungsgemäßen nichtlinearen Filterarchitektur. Figur 2a zeigt dabei die Filterarchitektur gemäß Formel (3), Figur 2b zeigt die Filterarchitektur gemäß Formel (5).

Im folgenden wird die Erfindung anhand eines bevorzugten Ausführungsbeispiels und mit Hilfe der Figuren näher beschrieben.

Die erfindungsgemäße nichtlineare Filterarchitektur sieht ein neuronales Netz vor zur Modellierung einer nichtlinearen Übertragungsfunktion, wobei dem neuronalen Netz, wie schematisch in Figur 2a dargestellt, eingangsseitig die Filtereingangssignale f(n), ..., f(n-i), ..., f(n-M), ein Zeitindexsignal i sowie die Werte p(n), ..., p(n-i), ..., p(n-M) des Parametervektors p zugeführt werden. Das neuronale Netz berechnet aus diesen Werten zu jedem Zeitpunkt i Ausgangswerten welche für die M+1 Zeitpunkte i = 0, ..., M aufsummiert werden, wodurch die Filterausgangsfunktion g(n) gemäß der Formel

$$(3) \quad g(n) = \sum_{i=0}^{M} N\big[f(n-i), i, p(n-i)\big]$$

gebildet wird. In Analogie zum FIR-Filter, ist dabei die Ausgangs funktion des Filters die Summe von Antworten auf zeitlich zurückliegende Eingangsdaten des Systems. Im Unterschied zu einem FIR-Filter hängt die erfindungsgemäße Filterarchitektur im allgemeinen in nichtlinearer Weise von den Eingangssignalen f, von der Zeit i und von dem Parametervektor p ab. Nimmt man an, daß das Filter in linearer Weise von den Eingangssignalen f abhängt, spezialisiert sich die erfindungsgemäße Filterarchitektur gemäß der Formel

$$(4) \quad g(n) = \sum_{i=0}^{M} f(n-i) \cdot N\big[i, p(n-i)\big]$$

auf ein lineares Filter, dessen Filterkoeffizienten durch das neuronale Netz aus dem Zeitindex i und den Werten des Parametervektors berechnet werden. Für den Fall, daß man auf die Eingabe eines Parametervektors verzichtet, spezialisiert sich die erfindungsgemäße Filterarchitektur gemäß der Formel

$$(5) \quad g(n) = \sum_{i=0}^{M} f(n-i) \cdot N\big[i\big]$$

weiter auf eine lineare FIR-Filterarchitektur, deren Ubertragungsfunktion durch das neuronale Netz aus dem Zeitsignal i berechnet wird. In Gleichung (5) gibt es nur ein Eingangssignal für das Netzwerk, welches die Zeit i ist, die seit dem Auftreten des Eingangssignals f(n-i) vergangen ist. Diese spezielle Architektur beschreibt ein FIR-Filter mit einer Filterantwortfunktion, die durch ein neuronales Netzwerk modelliert wird. Das hat an sich bereits bestimmte Vorteile. Falls M sehr groß ist (was in der folgenden Anwendung mit M = ca. 400 der Fall ist), sind Trainingsdaten in großer Zahl erforderlich, um sämtliche Koeffizienten eines herkömmlichen FIR-Filters zu spezifizieren.

Wenn dagegen das neuronale Netzwerk weniger als M Parameter besitzt, kann es eine effizientere Beschreibung der Filterfunktion ergeben, wodurch eine geringere Zahl von Trainingsdaten zum Erlernen einer angenäherten Filterantwort erforderlich ist.

Damit hängt auch die Tatsache zusammen, daß das neuronale Netzwerk eine implizite Zwangsbedingung auf die Komplexität der Filterantwort darstellt. Die Komplexität eines FIR-Filters wird normalerweise durch die Reduktion des Wertes M reduziert. Dies kann auf zwei Weisen geschehen: Zum einen, indem das Zeitfenster für die Antwortfunktion verringert wird. Dies ist in vielen Fällen unerwünscht, da die Aufgabenstellung ja gerade darin besteht, ein Filter mit einer langdauernden Antwortfunktion zu modellieren. Die andere Möglichkeit besteht darin, die Abtastfrequenz herabzusetzen, wodurch aber die Bandbreite des Filters reduziert wird. Die Komplexität des neuronalen Netzwerks ist dagegen definiert durch die zahl der Neuronen und Gewichte in diesem Netzwerk. Ein Netzwerk hat die Fähigkeit, Ressourcen so zu verteilen, wie sich die Komplexität der zu modellierenden Funktion aus den Daten ergibt. Hierdurch werden wenig Ressourcen dort verbraucht, wo die Daten auf eine gute Approximation hinweisen. Weiter unten wird anhand einer Anwendung verdeutlicht werden, wie das im Falle eines konkreten Anwendungsbeispieles geschieht. So hat in diesem Beispiel die Antwortfunktion einen schmalen Peak, so daß wenig Ressourcen des neuronalen Netzwerkes im Bereich des ansonsten flachen Verlaufs der Antwortfunktion eingesetzt werden.

Bei der durch Gleichung (4) gegebenen Filterarchitektur ist als zusätzliches Eingangssignal für das neuronale Netzwerk ein Parametervektor p vorgesehen. Mit Hilfe dieses Parametervektors p kann die Antwortfunktion durch äußere typischerweise langsam veränderliche Parameter beeinflußt werden. In medizinischen Anwendungen kann einer dieser Parameter die Respiration, in anderen Anwendungen eine Zeitverzögerung, eine Temperatur oder eine Feuchtigkeit sein. In diesen Fällen ist die Effizienz der erfindungsgemäßen Filterarchitektur besonders wichtig. Für ein neuronales Netzwerk bedeutet ein neuer Parameter einfach ein zusätzliches Eingangssignal. Wenn auf der anderen Seite für jedes mögliche p ein neues FIR-Filter trainiert werden müßte, würde die Zahl der Koeffizienten und damit die Zahl der erforderlichen Trainingsdaten sehr stark anwachsen. In gewisser Weise entspricht dies der Repräsentation einer Regressionsfunktion durch entweder eine Tabelle (look-up table, FIR-Filter) oder ein neuronales Netzwerk (erfindungsgemäße Lösung).

Zum Training des neuronalen Netzes, d. h. zur Adaption der erfindungsgemäßen Filterarchitektur wird vorteilhaft ein überwachtes Lernverfahren verwendet, bei der eine vorgegebene Energiefunktion, vorzugsweise gemäß der Formel

$$(6) \quad E = \frac{1}{2}\sum_{n}(g_m(n) - g(n))^2$$

minimiert wird. Hierbei bedeutet $g_m(n)$ die erwünschte Ausgangsfunktion des Systems zur Zeit n und g(n) die tatsächliche momentane Ausgangsfunktion des Filters. Die Energie E kann z. B. mit Hilfe eines Gradientenabstiegsverfahrens minimiert werden, wobei jedes Gewicht w des Netzwerks durch ein Gewichtsinkrement gemäß der Beziehung

$$(7) \quad \Delta w \propto \sum_{n}(g_m(n) - g(n)) \cdot \frac{dg(n)}{dw}$$

verändert wird. Hierbei ist gemäß Formel (3) der Gradient von g(n) gegeben durch

$$(8) \qquad \frac{dg(n)}{dw} = \sum_{i=0}^{M} \frac{\partial N\left[ f(n-i), i, p(n-i) \right]}{\partial w}$$

Alternativ zu Gradientenabstiegsverfahren sind auch andere, z. B. nicht-deterministische Verfahren zur Minimierung der Energiefunktion einsetzbar. Dies ist besonders dann vorteilhaft, wenn damit zu rechnen ist, daß die Energiefunktion eine Vielzahl lokaler Minima aufweist.

Eine schaltungstechnische Implementierung der erfindungsgemäßen nichtlinearen Filterarchitektur ist z. b. mit einer Schaltungsanordnung möglich, bei der ein Speicher vorgesehen ist, in dem die letzten M Werte und der momentane Wert des Eingangssignals f sowie der Parametervektor p gespeichert werden. Für die Berechnung eines neuen Wertes der Ausgangsfunktion g(n) werden die Werte f(n-i), p(n-i) und i zeitlich aufeinander folgend für die Zeitpunkte i:0, ... M an die Eingänge des neuronalen Netzwerkes angelegt, und die Ausgangsdaten dieses neuronalen Netzwerkes werden mit Hilfe eines Akkumulators aufsummiert. Zur Berechnung des Ausgangswertes für den jeweils folgenden Zeitpunkt werden die Speicherinhalte nach Art eines Schieberegisters verschoben und ein neuer Wert für das Eingangssignal und Parametervektor werden in den Speicher eingelesen.

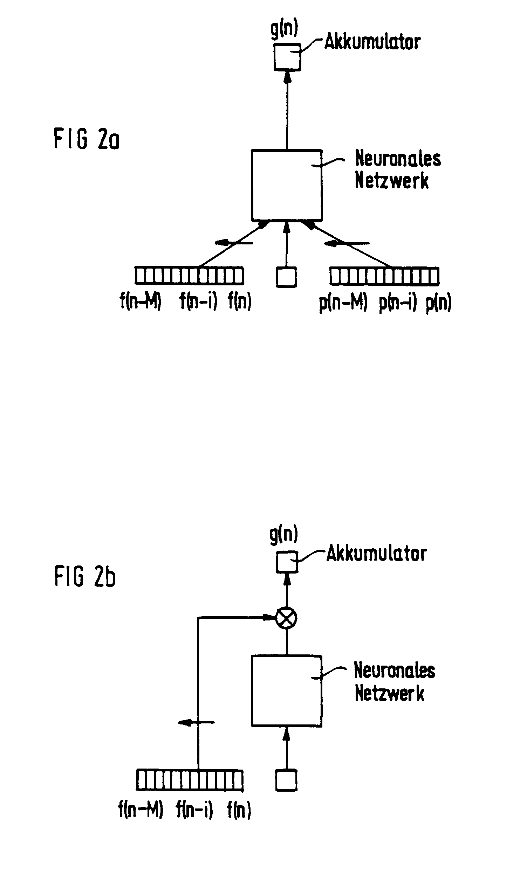

Obwohl es für die Trainingsphase vorteilhaft ist, ein neuronales Netzwerk einzusetzen, ist für die Anwendung des bereits adaptierten Filters häufig eine Ersetzung des neuronalen Netzwerkes durch eine entsprechende Tabelle (look-up table) vorteilhaft, die schaltungstechnisch durch einen entsprechenden Speicher realisiert werden kann. Diese Variante ist besonders im Fall der Filterarchitektur nach Formel (5) vorteilhaft. Diese spezielle Architektur des erfindungsgemäßen Filters ist in Figur 2b schematisch dargestellt. In diesem Fall werden die Werte f(n-i) nicht an das neuronale Netz angelegt, sondern mit den Ausgangswerten des neuronalen Netzes multipliziert.

Im folgenden werden mögliche Anwendungen der erfindungsgemäßen Filterarchitektur dargestellt. In der Magnetoenzephalographie (MEG) wird eine matrixförmige Anordnung hochsensitiver supraleitender SQUID-Detektoren verwendet, um in nicht invasiver Weise die äußerst schwachen magnetischen Felder, welche durch das Gehirn produziert werden, aufzunehmen (scannen). Diese Messungen werden verwendet, um starke Zentren neuronaler Aktivität, wie z. B. Epilepsiezentren, zu lokalisieren.

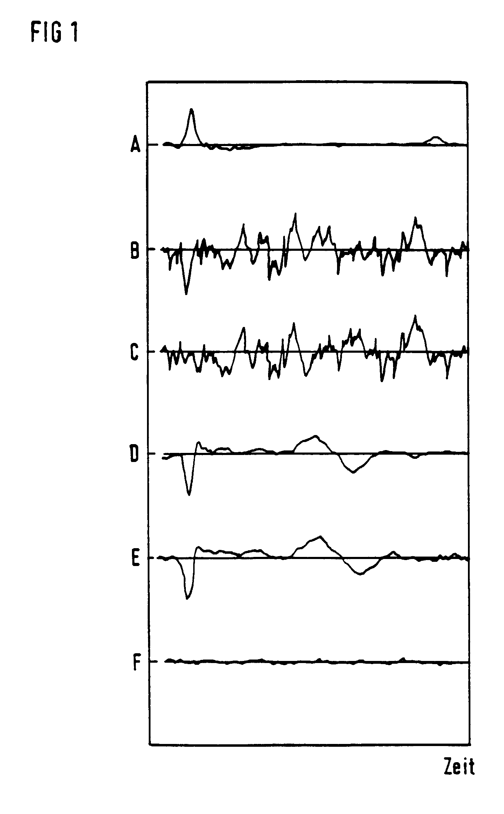

Figur 1 zeigt verschiedene Signalverläufe im Zusammenhang mit der Magnetoenzephalographie. Die Kurve A zeigt ein typisches Elektrokardiogramm. Kurve B zeigt das eigentliche MEG-Signal, dem eine sog. Kardiointerferenz, welche vom ECG herrührt, überlagert ist. Insbesondere ist der negative Ausschlag der Kurve während des QRS-Komplexes des ECG sichtbar. Kurve C zeigt das berichtigte MEG-Signal. Kurve D zeigt die Ausgangsfunktion des neuronalen Netzes. Kurve E zeigt die getriggerte Summation des MEG-Signals, wobei die Kardiointerferenz isoliert sichtbar wird. Kurve F zeigt die getriggerte Summation des berichtigten MEG-Signals, in der die Kardiointerferenz fehlt.

Da das magnetische Feld der Erde acht Größenordnungen über dem magnetischen Feld des Genirns liegt, müssen alle Messungen in einem magnetisch abgeschirmten Raum durchgeführt werden. Das magnetische Feld, welches durch den Herzmuskel erzeugt wird, ist eine Quelle von Störungen, die nicht auf einfache Weise abgeschirmt werden können, welche aber die Messungen stark beeinträchtigen.

Die Beseitigung der Kardiointerferenz ist eine schwierige Aufgabe, da weder das MEG noch die Kardiointerferenz unabhängig voneinander gemessen werden können, und da mathematische Modelle der physikalischen und physiologischen Vorgänge, welche die Kardiointerferenz erzeugen, nicht zur Verfügung stehen. Da es aber möglich ist, eine unabhängige Messung über die Quelle des Interferenzsignals in Form eines Elektrokardiogramms (ECG) aufzunehmen, ist es möglich, ein neuronales Netzwerk so zu trainieren, daß es ein Modell dieses Prozesses darstellt. Während der Trainingsphase sind die Eingangsdaten des neuronalen Netzwerkes die ECG-Signale und die gewünschten Ausgangsdaten sind das gemessene MEG-Signal. In der Anwendungsphase beschreiben die Ausgangsdaten des neuronalen Netzwerkes eine Schätzung der Kardiointerferenz, welche dann vom gemessenen MEG-Signal subtrahiert werden kann. Schon Widrow hat gezeigt (B. Widrow, S.D. Stearns, "Adaptive signal processing", Prentice Hall, Englewood Cliffs, N.J., 1985), daß es folgende notwendige Bedingungen für die Trainierbarkeit eines neuronalen Netzes, welches die Kardiointerferenzen modellieren kann, gibt:

- Das MEG-Signal und das Interferenzsignal sind unkorreliert.

- Das Referenzsignal und die Interferenz sind korreliert.

- Das gemessene Signal ist eine lineare Überlagerung der Interferenz und des MEG-Signals.

Experimente haben gezeigt, daß Versuche, ein lineares Filter dahingehend zu trainieren, daß es in der Lage ist, die Interferenz aus Messungen des EKGs vorherzusagen, fehlschlagen. Dies liegt hauptsächlich an der erforderlichen hohen Filterordnung und an den starken Nichtlinearitäten.

Bei Anwendung der erfindungsgemäßen Filterarchitektur wurde zunächst ein QRS-Detektor verwendet, um eine zeitverzögerte Schätzung des Herztriggers aus dem Elektrokardiogramm zu extrahieren. Ein weiteres Eingangssignal war die Amplitude des QRS-Komplexes für den letzten Herzschlag. Als weitere relevante Eingangsgröße könnte man die Respiration hinzuziehen, weil das Herz sich im allgemeinen durch die Atmung bewegt.

In unseren Experimenten wurde ein neuronales Netz mit radialen Basisfunktionen mit typischerweise zwanzig verborgenen Knoten (hidden units) verwendet. Figur Ic zeigt das MEG-Signal nach der Beseitigung der Interferenz. Um die erfindungsgemäße Methode zu testen, wurde das MEG-Signal mit der Herzschlagperiode als Trigger aufgemittelt. Falls die Kardiointerferenz nicht vollständig beseitigt würde, würde sie sich dabei aufaddieren und sollte nach einer gewissen Zahl von Mittelungen sichtbar werden. Figur If zeigt das nach der Beseitigung der Interferenz das aufgemittelte Signal im wesentlichen aus zufälligem Rauschen besteht. Weiterhin haben Simulationen die erfolgreiche Beseitigung der Kardiointerferenz bestätigt.

**Patentansprüche**

1. Nichtlineare Filterarchitektur mit folgenden Merkmalen:

   a) mit den Eingangsknoten eines neuronalen Netzes sind zur zeit i das zum Zeitpunkt n-i gehörige, gegebenenfalls mehrdimensionale Eingangssignal f(n-i) des nichtlinearen Filters, ein Zeitsignal für den Zeitpunkt i und ein zum Zeitpunkt n-i gehöriger Parametervektor p(n-i) verbunden;

   b) das Ausgangssignal g(n) des nichtlinearen Filters zum Zeitpunkt n ergibt sich durch Summation über M+1 zu den Zeitpunkten n,...,n-M gehörigen ausgangssignale des neuronalen Netzes nach der Formel

$$g(n) = \sum_{i=0}^{M} N[f(n-i), \overline{i}, p(n-i)]$$

   wobei $N[\ ]$ die Ausgangsfunktion des neuronalen Netzes bezeichnet.

2. Adaptationsverfahren für eine nichtlineare Filterarchitektur nach Anspruch 1, bei dem jedes Gewicht w des neuronalen Netzes in der Weise verändert wird, daß ein vorgegebenes Fehlermaß E, welches die über ein vorgegebenes Zeitintervall gemittelte Abweichung der Ausgangssignale g(n) des Filters von Soll-Ausgangssignalen $g_m(n)$ bewertet, durch die Veränderung der Gewichte des neuronalen Netzes minimiert wird, bei dem bei der Adaption das zu einem Zeitpunkt (n-i) gehörige Eingangssignal f(n-i) und der Zeitpunkt i als Eingangssignal des neuronalen Netzes angelegt werden.

3. Schaltungsanordnung einer nichtlinearen Filterarchitektur nach Anspruch 1, mit folgenden Merkmalen:

   a) es ist ein Speicher zur Speichrung des momentanen Filtereingangssignals f(n), der momentanen Werte p(n) des Parametervektors, und der letzen M Filtereingangssignale f(n-1),...,f(n-M) und Parametervektoren p(n-1),...,p(n-M) vorgesehen;

   b) es sind Mittel vorgesehen, die für M+1 aufeinanderfolgende Zeipunkte n-M,...,n den Eingangskniten des neuronalen Netzes die zu diesen Zeitpunkten gehörigen Speicherinhalte zuführen;

   c) es sind Mittel zur Summation der Ausgangswerte des neuronalen Netzes über die Zeitpunkte n-M,...,n vorgesehen.

4. Verwendung der Filterarchitektur nach Anspruch 1 oder der Schaltungsanordnung nach Anspruch 3 zur Beseitigung von Störsignalen in der digitalen Signalverarbeitung.

**5.** Verwendung nach Anspruch 4 zur Unterdrükkung der Kardiointerferenz in der Magnetoenzephalographie.

**6.** Verwendung nach Anspruch 4 zur Beseitigung von Motorgeräuschen.

## Claims

**1.** Non-linear filter architecture having the following features:

a) the input signal f(n-i) to the non-linear filter, which input signal is associated with time n-i and is possibly multi-dimensional, a time signal for the time i and a parameter vector p(n-i) associated with time n-i are linked, at time i, to the input nodes of a neural network;
b) the output signal g(n) of the non-linear filter at time n results from summation of M+1 output signals, which are associated with the times n,...,n-M, of the neural network, in accordance with the formula

$$g(n) = \sum_{i=0}^{M} N[f(n-i), \hat{i}, p(n-i)]$$

where N[ ] designates the output function of the neural network.

**2.** Adaptation method for a non-linear filter architecture according to Claim 1, in the case of which each weighting w of the neural network is varied in such a manner that a predetermined error E, which represents the value of the deviation, determined over a predetermined time interval, of the output signals g(n) of the filter from the required output signals $g_m(n)$, is minimized by varying the weightings of the neural network, in which, in the adaptation, the input signal f(n-i) associated with a time (n-i) and the time i are applied as input signal of the neural network.

**3.** Circuit arrangement of a non-linear filter architecture according to Claim 1, having the following features:

a) a memory is provided for storing the instantaneous filter input signal f(n), the instantaneous values p(n) of the parameter vector, the last M filter input signals f(n-1),...,f(n-M) and parameter vectors p(n-1),..., p(n-M);
b) means are provided which, for M+1 successive times n-M,...,n, supply the memory contents associated with these times to the input nodes to the neural network;
c) means are provided for summation of the output values of the neural network over the times n-M,...,n.

**4.** Use of the filter architecture according to Claim 1 or of the circuit arrangement according to Claim 3 for overcoming noise signals in digital signal processing.

**5.** Use according to Claim 4 for suppressing cardiointerference in magneto-encephalography.

**6.** Use according to Claim 4 for overcoming motor noise.

## Revendications

**1.** Architecture de filtrage non linéaire ayant les caractéristiques suivantes :

a) aux noeuds d'entrée d'un réseau neuronal sont reliés à l'instant i le signal d'entrée f(n-i) associé à l'instant n-i et le cas échéant pluridimensionnel du filtre non linéaire, un signal de temps pour l'instant i et un vecteur de paramètres p(n-i) associé à l'instant n-i ;
b) le signal de sortie g(n) du filtre non linéaire à l'instant n est obtenu par addition des M+1 signaux de sortie associés aux instants n,..., n-M du réseau neuronal, selon la formule

$$g(n) = \sum_{i=0}^{M} N[f(n-i),(i,p(n-i)]$$

où $N[\ ]$ désigne la fonction de sortie du réseau neuronal.

2. Procédé d'adaptation pour une architecture de filtrage non linéaire selon la revendication 1, consistant à modifier chaque poids w du réseau neuronal de telle manière qu'une grandeur d'erreur E donnée, laquelle évalue l'écart moyen calculé sur un intervalle de temps donné, entre les signaux de sortie g(n) du filtre et des signaux de sortie de consigne $g_m(n)$, soit minimisée par ladite modification des poids du réseau neuronal, et à appliquer lors de l'adaptation le signal d'entrée f(n-i) associé à un instant (n-i) et l'instant i comme signaux d'entrée du réseau neuronal.

3. Circuit d'une architecture de filtrage non linéaire selon la revendication 1, ayant les caractéristiques suivantes :

   a) est prévue une mémoire pour enregistrer le signal d'entrée de filtrage actuel f(n) , les valeurs actuelles p(n) du vecteur de paramètres et les derniers M signaux d'entrée de filtrage f(n-1),...,f(n-M) et vecteurs de paramètres p(n-1),..., p(n-M) ;
   b) sont prévus des moyens qui pour M+1 instants successifs n-M,..., n amènent aux noeuds d'entrée du réseau neuronal les contenus de mémoire associés à ces instants ;
   c) sont prévus des moyens pour additionner les valeurs de sortie du réseau neuronal pendant les instants n-M,...,n.

4. Utilisation de l'architecture de filtrage selon la revendication 1 ou du circuit selon la revendication 3 pour la suppression de signaux perturbateurs dans le traitement de signal numérique.

5. Utilisation selon la revendication 4 pour la suppression de la cardiointerférence dans la magnétoencéphalographie.

6. Utilisation selon la revendication 4 pour la suppression de bruits de moteur.

FIG 1

Zeit

FIG 2a

g(n) —Akkumulator

Neuronales Netzwerk

f(n–M)  f(n–i)  f(n)          p(n–M)  p(n–i)  p(n)

FIG 2b

g(n)
—Akkumulator

Neuronales Netzwerk

f(n–M)  f(n–i)  f(n)